# DEMANDE DE BREVET EUROPEEN

(11) **EP 1 921 042 A1**
(43) Date de publication de la demande: **14.05.2008**
(21) Numéro de dépôt: 06123873.9
(22) Date de dépôt: 10.11.2006
(51) Int. Cl.: B81C 5/00

(54) **Procédé de fabrication de pièces de micromécanique multiniveaux en silicium et pièces ainsi obtenues**

(71) Demandeur: ETA SA Manufacture Horlogère Suisse, 2540 Grenchen (CH)
(72) Inventeur: Marmy, Philippe, 2900, Porrentruy (CH); Helfer, Jean-Luc, 2502 Bienne (CH); Conus, Thierry, 2543, Lengnau (CH)
(74) Mandataire: Thérond, Gérard Raymond

(57) **Abrégé**

Le procédé comporte les étapes suivantes :
a) usiner dans une première plaquette de silicium (1) un premier élément (3) ou une pluralité desdits premiers éléments (3) en maintenant lesdits éléments (3) liés par des ponts de matière (5);
b) répéter l'étape a) avec une deuxième plaquette de silicium (2) pour usiner un deuxième élément (4), de forme différente de celle du premier élément (3), ou une pluralité desdits deuxièmes éléments (4);
c) à l'aide de moyens de positionnement (6, 7), appliquer face contre face les premiers et deuxièmes éléments (3, 4) ou les premières et deuxièmes plaquettes (1, 2);
d) effectuer une oxydation de l'ensemble formé à l'étape c) et
e) séparer les pièces (10) des plaquettes (1, 2).

Pièces de micromécanique horlogère obtenue selon le procédé.

## Description

### Domaine technique

La présente invention a pour objet un procédé de fabrication de pièces de micromécanique en silicium multiniveau et les pièces ainsi obtenues, utilisées notamment dans le domaine de la construction horlogère.

### Arrière-plan technologique

Les techniques actuelles de fabrication de pièces micromécaniques en silicium permettent d'obtenir une verticalité des flans des pièces suffisamment bien maîtrisée pour que ces pièces soient utilisées comme composants de mécanismes horlogers. La fabrication de pièces à plusieurs niveaux à partir d'une unique plaquette de silicium, à l'aide des techniques actuelles, reste toutefois très délicate.

Une méthode de production alternative de pièces multiniveaux est proposée ici. Cette méthode décrit comment obtenir des pièces silicium multiniveaux uniquement à partir de pièces silicium à un seul niveau produites à l'aide des méthodes actuelles.

### Résumé de l'invention

La présente invention vise donc à apporter une solution simple et économique à la fabrication de pièces de micromécanique multiniveaux à partir de plaquettes en silicium du commerce, lesdites pièces étant utilisées notamment dans la construction d'un mouvement horloger, qu'elles soient fixes ou mobiles.

A cet effet, l'invention concerne un procédé consistant à:
a) usiner dans une première plaquette de silicium par des moyens chimiques, physiques ou combinant les deux, un premier élément ou une pluralité desdits premiers éléments sur la même plaquette;
b) répéter l'étape a) avec une deuxième plaquette de silicium pour usiner un deuxième élément, de forme différente de celle du premier élément, ou une pluralité desdits deuxièmes éléments sur la même plaquette;
c) à l'aide de moyens de positionnement, appliquer face contre face les premiers et deuxièmes éléments ou les premières et deuxièmes plaquettes;
d) effectuer une oxydation thermique de l'ensemble formé à l'étape c), en présence d'un mélange oxydant pendant environ 2 à 4 heures, et
e) séparer les pièces.

Ce procédé permet de structurer avec précision chaque élément de la pièce finale à obtenir, avec des techniques ayant déjà fait leurs preuves pour des plaquettes ayant des épaisseurs inférieures à 1 mm.

Dans l'étape c) divers moyens de positionnement sont possibles pour assurer un positionnement précis des deux éléments devant constituer la pièce finale avant d'effectuer une oxydation thermique pour lier physiquement les deux éléments entre eux. Dans la description détaillée qui suit, deux exemples de moyens de positionnement sont donnés faisant appel, soit à des moyens de repérage formés dans chaque plaquette en même temps que la structuration des éléments qui seront alors liés entre eux par des ponts de matière, soit à l'utilisation d'un gabarit permettant de positionner les plaquettes l'une sur l'autre ou des éléments détachés de celles-ci.

L'étape d) d'oxydation de l'interface entre les plaquettes peut être effectuée par voie sèche avec de l'oxygène sec, ou par voie humide avec de la vapeur d'eau, par exemple dans un four chauffé à une température comprise entre 900°C et 1200°C selon des techniques bien connues de l'homme de l'art rapportées par exemple dans l'ouvrage "Semiconductors devices : physics and technology - editions John Wiley & Sons, ISBN 0-471-874-8-01.01.1985 p. 341-355".

Cette oxydation peut également être effectuée par tout autre moyen connu de l'homme de l'art, par exemple par la technique d'oxydation amplifiée par laser.

Il est également possible d'obtenir une pièce ayant plus de deux niveaux en usinant une troisième plaquette de silicium pouvant être intégrée dans l'étape c) du procédé, ou à l'issue de l'étape e) en répétant les étapes c), d), e).

Le procédé selon l'invention permet de fabriquer facilement des pièces de micromécaniques multiniveaux en silicium, tels que des paliers, des platines ou des ponts alvéolés, des mobiles de réduction pour un mouvement horloger, etc ...

### Brèves description des dessins

D'autres caractéristiques et avantages de la présente invention apparaîtront plus clairement dans la description qui suit d'exemples de réalisation, donnés à titre illustratif et non limitatif, en référence aux dessins annexés dans lesquels:
- la figure 1 est une représentation schématique des étapes du procédé permettant d'obtenir un palier avec pierre à trou et pierre contre-pivot;
- la figure 2 représente un autre palier pouvant être obtenu par le procédé, et
- la figure 3 représente un mobile réducteur pouvant être obtenu par le procédé.

### Description détaillée de l'invention

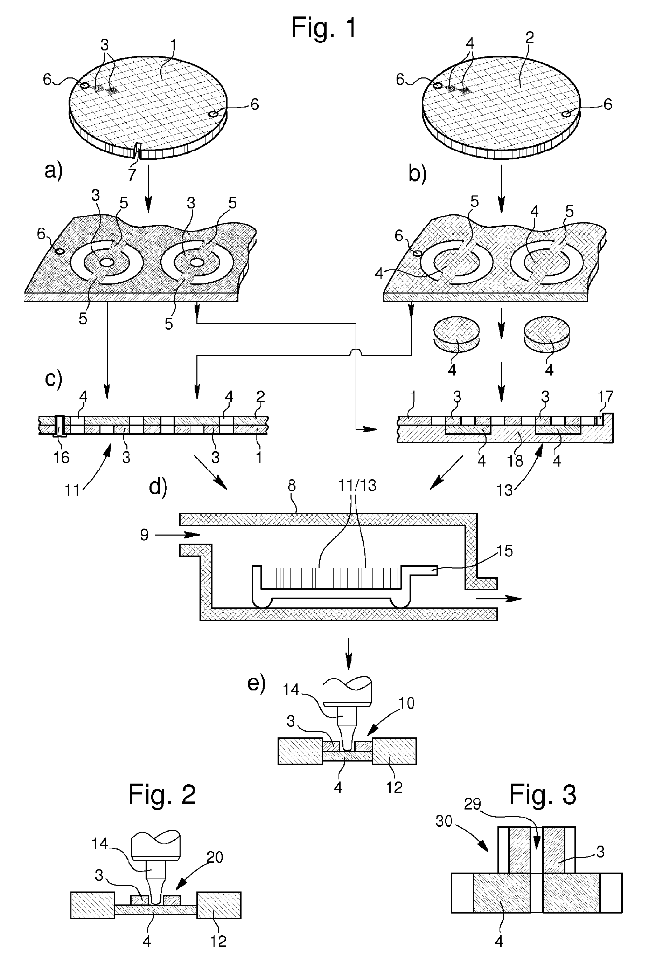

La figure 1 est une représentation schématique des étapes du procédé permettant d'obtenir un palier 10 en silicium dont un premier élément 3 forme la "pierre à trou" et dont un deuxième élément 4 forme la "pierre contre-pivot". Typiquement ces pierres ont des dimensions comprises entre 0,12 et 0,35 mm pour l'épaisseur et entre 0,70 et 1,80 mm pour le diamètre.

Dans une première étape a) on usine dans une première plaquette de silicium 1, le premier élément 3 mais de préférence une pluralité desdits premiers éléments 3. En effet en partant d'une plaquette de silicium du commerce, dont le diamètre peut varier de 75 mm à environ 300 mm, il est possible de structurer une pluralité d'éléments ayant un diamètre inférieur à 2 mm. Une telle plaquette a généralement une épaisseur inférieure à 1 mm, ce qui est compatible avec les dimensions horlogères, mais cette épaisseur peut être amenée à la cote précise désirée par attaque chimique. De préférence on fera en sorte qu'une face de la plaquette ne soit pas polie, qu'elle soit disponible comme telle dans le commerce, ou qu'on lui fasse subir un léger traitement abrasif.

La structuration des éléments 3 dans la plaquette 1 est effectuée par des méthodes connues de l'homme de l'art par photolithographie et attaque à travers le masque formé. Cette attaque peut être effectuée selon divers procédés également connus dans le domaine de l'usinage du silicium. Le procédé permettant d'avoir le meilleur rapport d'aspect, c'est-à-dire des flancs de découpe perpendiculaires à la surface de la pièce, est la technique RIE (Reactive Ion Ectching).

Cette technique, et les adaptations nécessaires à chaque cas particulier, étant bien connues de l'homme de l'art, ne sera donc pas décrite plus avant.

Dans cette première étape, des ponts de matière 5 sont prévus pour maintenir les éléments 3 liés à leur plaquette support 1. Cette structuration permet également de former dans la plaquette 1 des éléments de positionnement de ladite plaquette 1 par rapport à la plaquette 2. A titre d'exemple ces moyens de positionnement sont constitués par deux perçages 6, la référence 7 désignant d'autres moyens de positionnement qui seront expliqués plus loin.

Il est bien évident que les ponts de matière 5 entre les éléments de chaque plaquette ne sont pas forcément nécessaire selon le mode de positionnement utilisé.

Dans l'étape b), on reproduit le même processus que celui de l'étape a) à partir d'une deuxième plaquette 2 pour conformer les deuxièmes éléments 4, à savoir la "pierre contre-pivot", ainsi que des moyens de positionnement 6 qui coïncident avec les moyens de positionnement 6 de la première plaquette. Dans cet exemple les éléments 3 et 4 ont le même diamètre.

Lorsque les plaquettes 1 et 2 utilisées dans les étapes a) et b) ont au moins une face non polie, leur assemblage peut être effectué sans traitement de surface préalable en appliquant les faces non polies l'une contre l'autre. Si les deux faces de chaque plaquette sont polies on effectuera de préférence un traitement de surface préalable permettant de rendre les faces devant être appliquées l'une contre l'autre, soit légèrement rugueuses, soit revêtues d'un film d'oxyde de silicium un peu plus épais que l'oxyde natif.

L'étape c), telle que représentée dans la partie gauche du schéma, consiste à positionner des deux plaquettes 1, 2 l'une sur l'autre et à fixer cette position par exemple au moyen de chevilles 16 pour former un assemblage 11.

La partie droite du schéma illustre un deuxième exemple de positionnement. Les deuxièmes éléments 4 sont d'abord détachés de la deuxième plaquette 2 en brisant les ponts de matière 5, ou obtenus ainsi sans pont de matière 5, puis positionnés dans des alvéoles correspondantes d'un gabarit 18 en quartz. On vient ensuite appliquer la première plaquette 1 en la positionnant grâce à une fente 7 usinée dans son bord, ladite fente 7 venant s'engager dans un ergot 17 du gabarit 18 pour former un assemblage 13. En utilisant un gabarit 18 comportant des alvéoles ayant la profondeur appropriée on peut également avoir les premiers éléments 3 séparés de la première plaquette 1 pour les placer dans le gabarit 18.

Dans l'étape d) on place une série d'assemblages 11 ou 13 sur un chariot 15 qu'on introduit dans un four 8 porté à une température comprise entre 900° C et 1200° C et dans lequel on fait circuler un mélange oxydant 9 pendant environ ? heures. Cette étape d'oxydation, qui va lier les deux plaquettes 1, 2 par des liaisons de type siloxane peut-être effectuée, soit par voie sèche avec un mélange comprenant un gaz porteur inerte et de l'oxygène sec, soit par voie humide en remplaçant l'oxygène par de la vapeur d'eau.

A l'issue de cette étape, on sort le chariot 15 du four 8, on laisse les assemblages 11 ou 13 revenir à température ambiante, puis on sépare les pièces 10 ainsi formées en brisant les ponts de matière 5 résiduels. Le palier 10 ainsi obtenu est alors prêt à être utilisé en le montant dans un chaton 12, pour recevoir un pivot 14 d'un mobile de mouvement d'horlogerie.

La figure 2 représente une variante de réalisation dans laquelle les pierres 3, 4 du palier 20 n'ont pas le même diamètre. Dans ce cas on utilisera de préférence la variante de procédé faisant appel à un gabarit 18, ledit gabarit pouvant avantageusement être formé d'alvéoles multi-étages permettant à la fois d'empiler les éléments 3 et 4 et de les positionner les uns par rapport aux autres.

La figure 3 représente une autre pièce 30 pouvant être obtenue selon le procédé de l'invention. Il s'agit d'un mobile de réduction formé par assemblage dans lequel l'élément 3 est le pignon et l'élément 4 la roue dentée, les deux éléments 3, 4 étant traversés par un trou d'axe (29).

Les exemples qui viennent d'être décrits concernent la fabrication d'une pièce de micromécanique à deux niveaux, mais il est bien évident qu'on pourrait avoir un plus grand nombre de niveaux. Il suffit pour cela de partir de trois plaquettes de silicium ou plus, ou de réitérer le procédé à l'issue de l'étape e).

L'invention n'est pas limitée aux exemples qui viennent d'être décrits et l'homme de métier peut mettre en oeuvre le procédé pour obtenir d'autres pièces de micromécanique.

Elle n'est pas non plus limitée à des pièces de petites dimensions. Le procédé peut avantageusement être mis en oeuvre pour des pièces de plus grandes dimensions telles que des platines ou des ponts d'un mouvement horloger, comportant des noyures. De telles pièces ont des épaisseurs de l'ordre de 2 mm et ne seraient pas réalisables à partir d'une seule plaquette de silicium du commerce.

## Revendications

1. Procédé de fabrication d'une pièce de micromécanique (10, 20, 30) en silicium mono ou polycristallin ayant au moins deux niveaux comportant les étapes consistant à :
a) usiner dans une première plaquette de silicium (1) par des moyens chimiques, physiques ou combinant les deux, un premier élément (3) ou une pluralité desdits premiers éléments (3);
b) répéter l'étape a) avec une deuxième plaquette de silicium (2) pour usiner un deuxième élément (4), de forme différente de celle du premier élément, ou une pluralité desdits deuxièmes éléments (4);
c) à l'aide de moyens de positionnement (6, 7), appliquer face contre face les premiers et deuxièmes éléments (3, 4) ou les premières et deuxièmes plaquettes (1, 2);
d) effectuer une oxydation de l'ensemble formé à l'étape c) et
e) séparer les pièces (10) des plaquettes (1, 2).

2. Procédé selon la revendication 1, **caractérisé en ce que** l'oxydation à l'étape d) de l'ensemble s'effectue dans un four (8) chauffé à une température comprise entre 900 °C et 1200 °C en présence d'un mélange oxydant (9) pendant environ 2 à 4 heures.

3. Procédé selon la revendication 1, **caractérisé en ce que** les moyens de positionnement (6, 7) d'une plaquette (1) par rapport à l'autre plaquette (2) sont usinés dans chaque plaquette (1, 2) en même temps que les premiers et deuxièmes éléments (3, 4), qui sont alors liés entre, sur leurs plaquettes respectives par des ponts de matière (5).

4. Procédé selon la revendication 2, **caractérisé en ce que** les moyens de positionnement des plaquettes (1, 2) sont constitués par au moins deux trous (6) dans lesquels sont engagés des chevilles de positionnements (16).

5. Procédé selon la revendication 1, **caractérisé en ce que**, à l'issu des étapes a) ou b) au moins un élément (3 ou 4) se trouve séparé de sa plaquette support (1 ou 2) pour être positionné dans un gabarit en quartz (18) sur lequel on vient appliquer la deuxième plaquette dans un logement dudit gabarit prévu à cet effet, ladite plaquette comportant sur son bord au moins une fente (7) venant s'engager dans une nervure correspondante (17) du gabarit (18).

6. Procédé selon la revendication 1, **caractérisé en ce que**, à l'issue des étapes a) et b), les premiers et deuxièmes éléments (3, 4) se trouvent séparés de leurs plaquettes respectives (1, 2) et positionnés dans un gabarit en quartz (18) à deux niveaux.

7. Procédé selon la revendication 1, **caractérisé en ce que** les faces des plaquettes (1, 2) devant être appliquées l'une contre l'autre dans l'étape c) sont préalablement oxydées.

8. Procédé selon la revendication 1, **caractérisé en ce que** les faces des plaquettes (1, 2) devant être appliquées l'une contre l'autre dans l'étape c) subissent un traitement préalable pour leur conférer une certaine rugosité.

9. Procédé selon les revendications 1 à 8, **caractérisé en ce qu'**il comporte en outre au moins une étape supplémentaire consistant à usiner au moins une troisième plaquette pour former un troisième élément assemblé avec les deux précédents dans les étapes c), d), e) pour former au moins un troisième niveau.

10. Pièce de micromécanique multiniveau en silicium obtenue selon une quelconque des revendications 1 à 9 **caractérisée en ce qu'**elle constitue un composant d'un mécanisme horloger.

11. Pièce d'horlogerie **caractérisée en ce qu'**elle incorpore un composant multiniveaux en silicium selon la revendication 10.
